Europäisches Patentamt

European Patent Office

Office européen des brevets

(11) Publication number: **0 472 199 A1**

# EUROPEAN PATENT APPLICATION

(21) Application number: **91114094.5**

(22) Date of filing: **22.08.91**

(51) Int. Cl.5: **H01L 21/56, B29C 45/14**

(30) Priority: **22.08.90 JP 220881/90**

(43) Date of publication of application:
**26.02.92 Bulletin 92/09**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kojima, Shinjiro**
**3-20, Akamatsu-cho**
**Chigasaki-shi, Kanagawa-ken(JP)**

(74) Representative: **Füchsle, Klaus, Dipl.-Ing. et al**
**Hoffmann . Eitle & Partner Patentanwälte**
**Arabellastrasse 4**
**W-8000 München 81(DE)**

(54) Method of manufacturing plastic molded semiconductor device and apparatus for manufacturing the same.

(57) A manufacturing apparatus and a method of manufacturing a plastic molded semiconductor device comprising the steps of mounting semiconductor elements (2) on element mount portions (1b) of a lead frame (1), connecting the elements (2) and the lead frame (1) by means of metal lead wires (3), holding lead portions (1a) of the lead frame (1) by a pair of metal molds (5a, 5b) and positioning the element mount portions (1b) within a molding space of the metal molds, holding the opposite end portion of the lead frame by spring-biased hold pins (7a, 7b, 70a, 70b) provided at the metal molds from the both surfaces thereof, and releasing by the molding pressure of a plastic material injected into the molding space of the metal molds that the hold pins hold the opposite end portion (1d) of the frame (1) and completely molding the lead frame except for the lead portions (1a) and the semiconductor elements (2) as the result of the fact that the plastic material flows into the molding space during the above releasing.

FIG. 6

## BACKGROUND OF THE INVENTION

This invention relates to a method of manufacturing a plastic molded semiconductor device and an apparatus for manufacturing such a device, and more particularly to a method of manufacturing a semiconductor device having a practically sufficient withstand voltage after assembled and having an excellent insulating property, and an apparatus for manufacturing such a device.

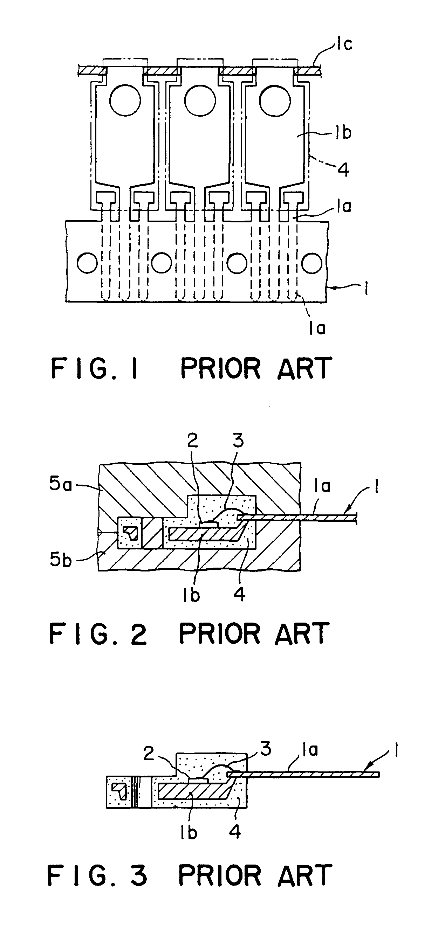

In a conventional method of manufacturing a plastic molded semiconductor device, chips 2 (only an indication of a single chip is made in FIG. 2) are mounted on respective chip mount portions 1b of a lead frame 1 shown in FIG. 1 to carry out connection wirings between the respective chips 2 and the lead frame 1 by means of metal lead wires 3 thereafter to hold the chip mount portions 1b by metal molds 5a and 5b to fill plastic material 4 into the cavity therebetween as shown in FIG. 2, or to provide hang pin portions 1c (slanting line portions in FIG. 1) at the lead frame 1 shown in FIG. 1 to hold these hang pin portions 1c by metal molds 5a and 5b to fill plastic material 4 into the cavity therebetween, thus to manufacture a plastic molded semiconductor device shown in FIG. 3. In FIGS. 1 to 3, reference numeral 1a denotes lead portions projected from the solidified plastic package toward the outside and serving to connect the chips 2 and the lead frame 1 by means of the metal lead wires 3.

In FIG. 1, double dotted lines represent an outside shape of the plastic molded block or package 4, and broken lines represent the lead portions 1 formed by cutting after the plastic molding is completed.

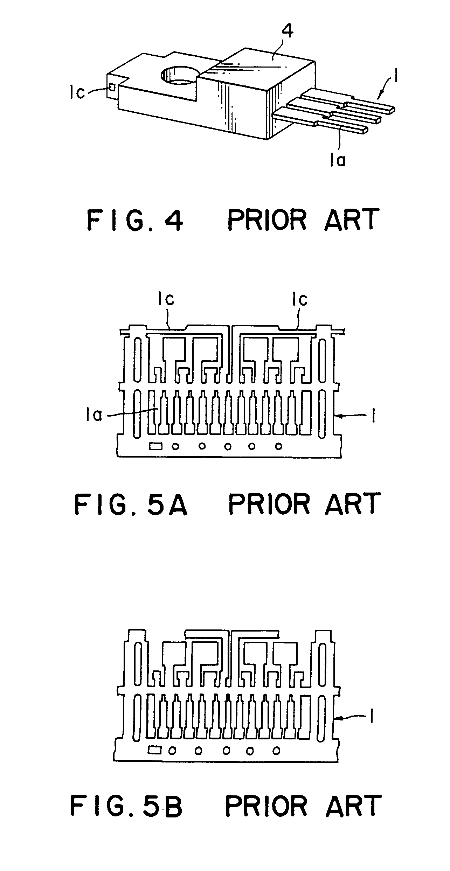

As an alternative example, a lead frame 1 having hang pin portions is shown in FIG. 5A and a lead frame having no hang pin portion is shown in FIG. 5B.

In such a conventional manufacturing method, in the case where no hang pin portion 1c is provided at the lead frame 1, since each chip mount portion 1b is not fixed within the cavity defined or formed by the metal molds 5a and 5b, there was the possibility that there may occur the problems that the thickness of the plastic molded portion 4 on the back side of the chip mount portion 1b formed by injection of the plastic material 4 vary (bending of the plastic molded portion), or occasionally the back side of the chip mount portion is exposed, or the like, with the result that an electric insulation by the plastic molded block 4 cannot be satisfactorily provided.

To prevent the above-mentioned bending, a method is adopted to provide hand pin portions 1c at the front end portions of the chip mount portions 1b to hold the hang pin portions 1c by metal molds

to carry out plastic molding. With this method, however, since the hang pin portions 1c are cut off after plastic molding, hang pin portions 1c are exposed to the surface of a semiconductor device comprised of metal as shown in FIG. 4. This results in the problem that the electric insulating distance between the semiconductor device and a mounting plate (chassis) at the time of assembling becomes short, thus making it difficult to provide a predetermined withstand voltage (tolerable even if AC voltage of 2.5 KV is applied for one minute).

## SUMMARY OF THE INVENTION

With the above circumstances in view, this invention has been made, and its object is to provide a method of manufacturing a plastic molded semiconductor device and an apparatus for manufacturing such a semiconductor device, which can improve as far as possible the insulating property of the plastic molded semiconductor device.

To achieve the above-mentioned object, a manufacturing method of this invention comprises the steps of mounting semiconductor elements on element mount portions of a lead frame; connecting the elements and lead portions of the lead frame by means of metal lead wires; holding the lead portions of the lead frame by a pair of metal molds prior to metal molding; holding the opposite end portions of the lead portions of the lead frame by means of a pair of hold pins having a predetermined working force in a direction to hold the opposite end portions of the lead portions of the lead frame and each including a pressure receiving portion formed thereat for releasing the holding by a reaction force in an opposite direction to the above-mentioned direction; and plastic-molding the entirety of the lead frame and the elements connected.

Further, a manufacturing apparatus of this invention comprises metal molds for defining or forming a cavity allowing a lead frame to be placed therewithin in order to carry out plastic molding; a pair of hold pins projected by a spring force into the cavity to hold therebetween the opposite end portions of the lead portions of the lead frame by the front end portions thereof and each including, at the front end portions thereof, a pressure receiving surface for receiving a molding pressure at the time of injection of plastic material, and a plastic material injection mechanism for injecting plastic material into the cavity at a predetermined pressure thus to mold the entirety of a semiconductor device and the lead frame.

In accordance with the method of the invention featured as above, prior to plastic molding, the lead portions of the lead frame are held by a pair of metal molds, e.g., arranged in upper and lower directions, and the opposite end portions on the opposite side of the lead portions of the lead frame, i.e., the end portion on the element mount portion side are held by the hold pins. In this state, when plastic material is injected into the cavity, molding pressure of plastic material is exerted on the pressure receiving portions of the hold pins, so the pin front ends are away from the lead frame against the predetermined working force, e.g., a spring force based on a spring, etc. As a result, a gap is formed therebetween. Plastic material flows into the gap, so the portions except for the lead portions are plastic-molded.

Thus, the insulating property of the semiconductor device can be improved as far as possible.

Further, in accordance with the manufacturing apparatus of the invention constructed as described above, prior to plastic molding, the hold pins hold therebetween the end portions on the opposite side of the lead portions through the element mount portions of the lead frame by a working force e.g., resilient spring force, etc. In this state, when the plastic material injection mechanism injects plastic material into the cavity, the cavity is filled with plastic material. By a molding pressure of the plastic material at this time, the hold pins undergo reaction force in a direction opposite to that of the working force to release holding of the end portions opposite to the lead frame, so the both surfaces of the frame end portion and the front end surfaces of the pins are spaced by a fixed distance. Plastic material injected flows into the gap thus formed. As a result, portions except for the lead portions are entirely molded. Thus, the insulating property of the manufactured semiconductor device can be improved as far as possible.

## BRIEF DESCRIPTION OF THE DRAWINGS

In the accompanying drawings:
FIG. 1 is a plan view showing a lead frame used in a conventional semiconductor device;
FIG. 2 is a cross sectional view showing an apparatus for manufacturing a conventional semiconductor device;
FIG. 3 is a cross sectional view showing a semiconductor device manufactured by the conventional manufacturing apparatus;
FIG. 4 is a perspective view showing the semiconductor device shown in FIG. 3;
FIGS. 5A and 5B are plan views showing lead frames of the types different from that of FIG. 1 used in the conventional semiconductor device, respectively;
FIG. 6 is a cross sectional view showing the configuration of a manufacturing apparatus used in a semiconductor manufacturing method according to a first embodiment of this invention;
FIG. 7 is a cross sectional view showing, in an enlarged scale, a portion of the manufacturing apparatus of FIG. 6 for explaining the operation of the first embodiment;
FIGS. 8 and 9 are a cross sectional view and a perspective view showing a semiconductor device manufactured by the apparatus shown in FIG. 6, respectively;
FIG. 10 is a cross sectional view showing the configuration of a manufacturing apparatus used in a semiconductor manufacturing method according to a second embodiment of this invention;
FIG. 11 is a cross sectional view showing the configuration of a manufacturing apparatus used in a semiconductor manufacturing method according to a third embodiment of this invention;
FIG. 12 is a cross sectional view showing a plastic molded semiconductor device with a radiating plate manufactured by the respective embodiments of this invention; and
FIGS. 13A and 13B are cross sectional views showing the configuration of the essential part of a semiconductor manufacturing apparatus according to a fourth embodiment of this invention, respectively.

## DETAILED DESCRIPTION OF THE PREFERRED EMBODIMENTS

Preferred embodiments of a method of manufacturing a plastic molded semiconductor device and an apparatus for manufacturing such a semiconductor device according to this invention will now be described in detail with reference to the attached drawings.

The same reference numerals are attached to the portions corresponding to those of the prior art, respectively, and explanation thereof will be given below.

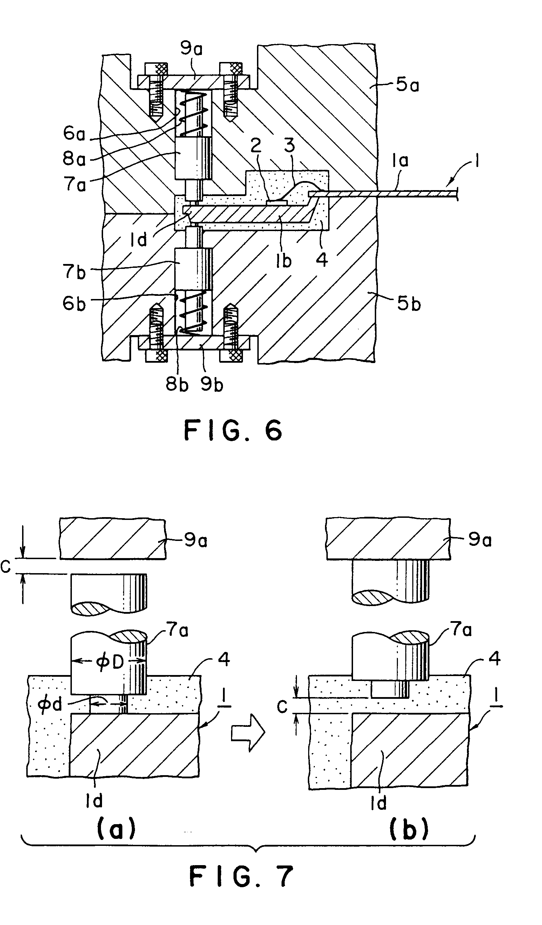

Initially referring to FIG. 6, there is shown the configuration of an apparatus for manufacturing a semiconductor device according to a first embodiment of this invention. The manufacturing apparatus of the first embodiment comprises a pair of metal molds 5a and 5b, e.g., arranged in upper and lower directions, which define or form a cavity as a molding space into which plastic material is filled when the metal molds are in contact with other and holding a lead portion 1a of a lead frame 1 therebetween, stepped pins 7a and 7b serving as hold pins provided slidably in holes 6a and 6b bored at portions of the metal molds 5a and 5b corresponding to an opposite end portion 1d positioned on the opposite side to the lead portion 1a through a semiconductor element mount portion 1b of the lead frame 1 in the state where the lead frame 1 is arranged within the cavity, springs 8a and 8b provided on the bottom end portion sides of the stepped pins 7a and 7b and rendering, to these pins, a resilient spring force for biasing these pins toward the opposite end portion 1d side of the frame 1, and stoppers 9a and 9b affixed by means of, e.g., bolts at the opening portions of the holes 6a and 6b in order to support the bottom end portion sides of the springs 8a and 8b. In FIG. 6, reference numerals 2 and 3 denote a semiconductor element and a metal lead wire for connecting the element 2 to the frame 1.

The operation of the above-described first embodiment will now be described with reference to FIGS. 7(a) and 7(b). It is to be noted that an indication of the upper metal mold 5a is omitted and only the relationship of the stepped pin 7a and the stopper 9a on the upper mold side are illustrated in FIGS. 7(a) and 7(b). When plastic material 4 is injected into the cavity defined by the metal molds 5a and 5b, i.e., prior to application of pressure, respective front end portions of the stepped pins 7a and 7b as the hold pins hold therebetween the opposite end portion of the lead frame 1 by a resilient spring force of the springs 8a and 8b. Further, the bottom end portions of the stepped pins 7a and 7b are spaced by a predetermined distance C (e.g., 2 to 3 mm) from the stoppers 9a and 9b (see FIG. 7(a)). In this state, when plastic material 4 is filled within the cavity defined by the metal molds 5a and 5b and pressure is applied, a molding pressure (e.g., 80 to 150 Kg/cm$^2$) is applied to the stepped portions as pressure receiving surfaces of the stepped pins 7a and 7b. As a result, the bottom end portions of the stepped pins 7a and 7b are moved until they come into contact with the stoppers 9a and 9b. Thus, the front end surfaces of the stepped pins 7a and 7b holding therebetween the opposite end portion 1d of the lead frame 1 are spaced by the distance C from the opposite end portion 1d, and plastic material 4 flows into the gap of the distance C and is filled thereinto (see FIG. 7(b)).

Namely, the thickness of the plastic molded block 4 on the opposite end portion 1d side held by the stepped pins 7a and 7b becomes equal to the distance C. It is to be noted that it is sufficient that the diameter D (see FIG. 7(a)) of the thick portion of the stepped pins 7a and 7b is, e.g., about 2 to 3 mm, and the thin portion thereof (see FIG. 7(a)) is about 1 to 2 mm. Further, it is desirable that the resilient spring force of the springs 8a and 8b is set to a less than one half of the product of the area ($= \pi \cdot (D^2 - d^2)/4$) of the stepped portion and the molding pressure. It is to be further noted that a draft taper may be provided at the portions having a diameter d of the thin portion of the stepped pins 7a and 7b.

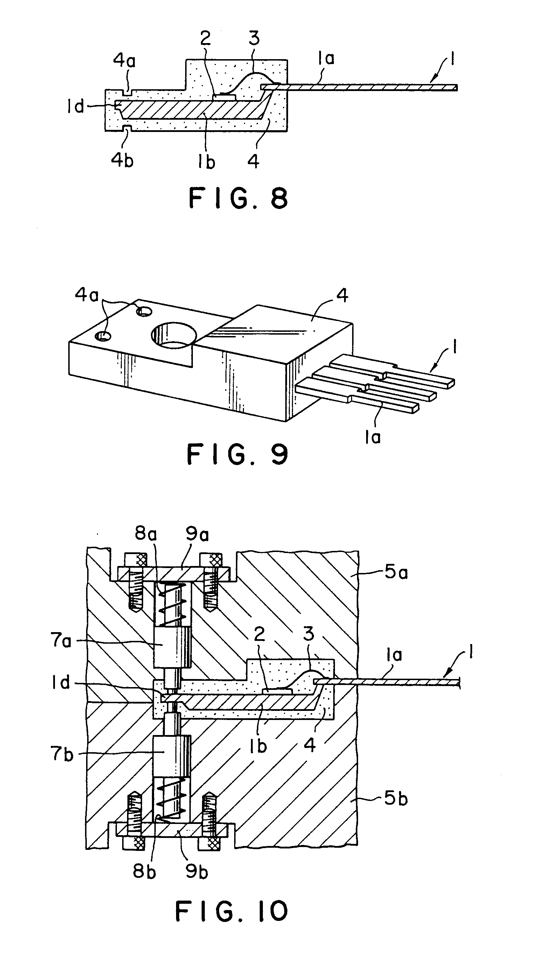

A semiconductor element manufactured in a manner as described above is shown in FIGS. 8 and 9. In this semiconductor element, pin holes 4a and 4b are left at the portions held by the stepped pins 7a and 7b, but the metal portion except for the lead portion 1a of the lead frame 11 is entirely coated by the plastic material 4. Thus, in accordance with the first embodiment, it is possible to improve the insulating property of the semiconductor device as far as possible.

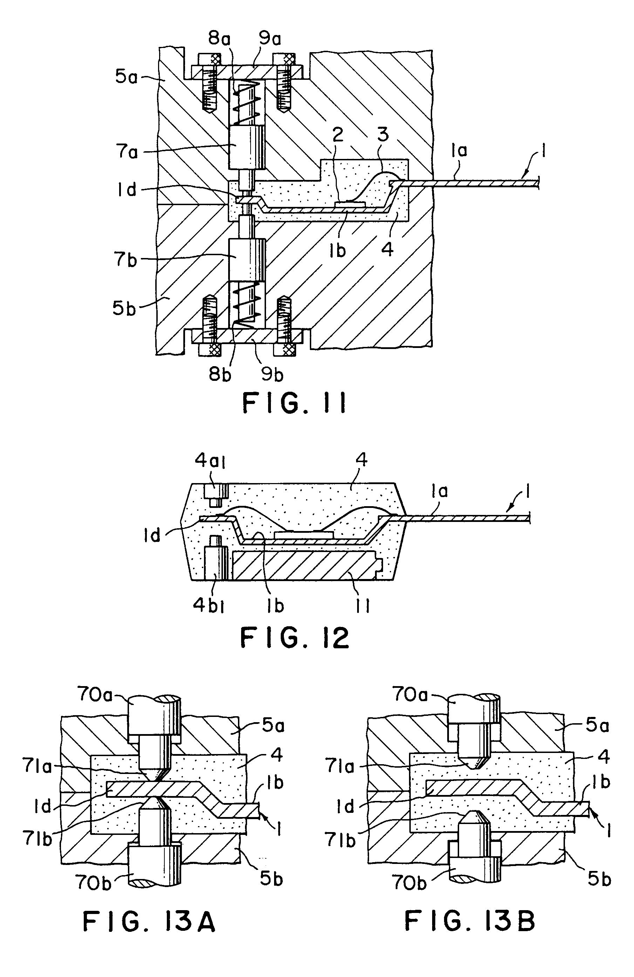

In the above-mentioned first embodiment, the thick portion on the opposite end portion 1d of the lead frame 1 is held by the stepped pins 7a and 7b, but this invention is not limited to such an implementation. For example, as in a second embodiment shown in FIG. 10, a thin portion may be provided on the front end side of the lead frame 1 in order to increase the above-described distance C to hold the thin portion by the stepped pins 7a and 7b. In addition, as in a third embodiment shown in FIG. 11, bending processing may be implemented to the opposite end portion 1d of the lead frame 1 to hold the bending processed opposite end portion 1d by stepped pins 7a and 7b, thus making it possible to elongate the above-described distance C.

Further, it is a matter of course that the manufacturing apparatus and the manufacturing method according to this invention may be used for manufacturing a plastic insulated semiconductor device provided with a radiating plate 11. Also in this case, pin holes 4a1 and 4b1 are formed at the portion on the opposite end portion 1d side of the lead frame 1 held by the stepped pins 7a and 7b of a manufactured semiconductor device.

Furthermore, while it has been described in the above-described first to third embodiments that stepped pins 7a and 7b are used as the hold pins, this invention is not limited such an implementation. Namely, as long as the hold pins are adapted to receive a molding pressure when plastic material is injected into the cavity to release holding of the lead frame 1 and their front end surfaces thereof can form a gap with respect to the lead frame, such hold pins may take any shape. For example, as in a fourth embodiment shown in FIGS. 13A and 13B, also in the case where tapered pins 70a and 70b are used as the hold pins, release of holding of the lead frame 1 by the molding pressure can be carried out. These tapered pins 70a and 70b are provided at the front end portions thereof with pressure receiving tapered surfaces 71a and 71b, respectively. Other components such as the springs, etc. are the same as those of the first to third embodiments. As shown in FIG. 13A, the tapered pins 70a and 70b within the cavity prior to injection of plastic material hold the opposite end portion 1d of the lead portion 1a of the lead frame 1 from the both sides thereof. In this state, when plastic material is injected, the plastic material is filled within the cavity, and a molding pressure of the plastic material at that time is received by the pressure tapered surfaces 71a and 71b. Thus, the tapered pins 70a and 70b release the holding state of the end portion 1d against a resilient spring force of spring (not shown). As a result, gaps are formed between the front end surfaces of the tapered pins 70a and 70b and the end portion 1d. Since the plastic material 4 is still supplied at this time, plastic material is filled also into such gaps. Thus, all the portions except for the lead portions 1a of the lead frame 1 are coated and insulated. Reference signs in the claims are intended for better understanding and shall not limit the scope.

**Claims**

1. A method of manufacturing a plastic molded semiconductor device, comprising the steps of mounting semiconductor elements (2) on element mount portions (1b) of a lead frame (1), connecting said elements and lead portions (1a) of said lead frame by means of metal lead wires (3), and plastic-molding the entirety of said lead frame and said elements connected except for said front end portion of said lead portion (1a),

   said method comprising the steps of:

   holding said lead portions (1a) of said lead frame (1) by means of a pair of metal molds prior to plastic molding,

   holding the opposite end portions (1d) of said lead portions (1a) of said lead frame (7) by means of a pair of hold pins (7a, 7b, 70a, 70b) having a predetermined working force in a direction to hold said opposite end portion (1d) thereof and each including a pressure receiving portion formed thereat for releasing the holding by a reaction force in an opposite direction to the above-mentioned direction, and

   molding plastic material into portions (C) between said front end portions and said lead frame when said hold pins release holding of said opposite end portions of said lead frame (1) as the result of the fact that said pressure receiving portions receive a molding pressure produced by injection of said plastic material into a cavity defined or formed within said metal molds.

2. A method of manufacturing a semiconductor device as set forth in claim 1, wherein said holding step is comprised of a step of carrying out holding by said hold pins each comprised of a stepped pin (7a, 7b) including a stepped portion comprised of a pressure receiving surface substantially in parallel to the both surfaces of said opposite end portion of said lead frame (1) and a projection projected from the center of said pressure receiving surface.

3. A method of manufacturing a semiconductor device as set forth in claim 2, wherein said holding step is comprised of a step of holding said opposite end portion (1d) of said lead frame (1) from the both surfaces thereof by a spring resilient force of said hold pins (7a, 7b) movably attached through springs (8a, 8b) to said metal molds.

4. A method of manufacturing a semiconductor device as set forth in claim 3, wherein said plastic material molding step is comprised of a step such that said pressure receiving surface receives molding pressure by molding of the plastic material (4), so said pressure receiving surface is away from said opposite end portion (1d) by the molding pressure against said spring resilient force, whereby said plastic material flows into a gap thus formed to mold said opposite end portion (1d).

5. A method of manufacturing a semiconductor device as set forth in claim 1, wherein said hold pins are each comprised of a tapered pin (70a, 70b) such that the bottom end side thereof is provided at said metal molds through a spring (8a, 8b), and the front end side thereof serves as a flat surface substantially in parallel to the both surfaces of said opposite end portion through a conic surface (71a, 71b) serving as a pressure receiving tapered surface, said holding step being comprised of a step of holding said both surfaces of said opposite end portion (1d) by said flat surfaces of said hold pins (70a, 70b) as the result of the fact that each hold pin is biased by a resilient force of said spring (8a, 8b).

6. A method of manufacturing a semiconductor device as set forth in claim 5, wherein said plastic material molding step is comprised of a step such that each of said pressure tapered surfaces receives a molding pressure by injection of plastic material, so said pressure tapered surface (71a, 71b) is away from said each opposite end portion by said molding pressure against a resilient force of said each spring (8a, 8b), whereby said plastic material (4) flows into a gap thus formed to mold said opposite end portion (1d).

7. An apparatus for manufacturing a plastic molded semiconductor device comprising a pair of metal molds (5a, 5b) for holding lead portions (1a) of a lead frame (1) on which semiconductor elements (2) are mounted, and a plastic material injection mechanism for injecting plastic material (4) into the surrounding portion of said lead frame (1) held by said metal molds (5a, 5b),

wherein there are provided a pair of hold pins (7a, 7b, 70a, 70b) respectively attached to said metal molds (5a, 5b) through springs (8a, 8b), said hold pins (7a, 7b, 70a, 70b) being adapted to hold the opposite end portions (1d) of said lead portions (1a) of said lead frame (1) by a predetermined working force of said springs (8a, 8b) prior to plastic molding, and each including a pressure receiving surface formed thereat to receive a working force in an opposite direction to said holding direction.

8. An apparatus for manufacturing a semiconductor device as set forth in claim 7, wherein said hold pin (7a, 7b, 70a, 70b) is comprised of a cylindrical shaft portion slidably accommodated in a hole bored at a position corresponding to said opposite end portion (1d) of said lead frame (1) in said metal molds; a bottom end portion adapted so that the other end side of said spring (8a, 8b) held on one end side thereof by a stopper (9a, 9b) attached at a hole opening portion so as to cover said hole is in contact with said bottom end portion, and a front end portion projected into a plastic material molding space defined or formed within said metal molds (5a, 5b) by a resilient spring force to hold said opposite end portion (1d) of said lead frame (1) from the both surfaces thereof.

9. An apparatus for manufacturing a semiconductor device as set forth in claim 8, wherein said hold pin is comprised of a stepped pin (7a, 7b) having a stepped portion including a pressure receiving surface serving as said pressure receiving portion comprised of an end surfaces of said shaft portion respectively in parallel to the both surfaces of said lead frame end portion, and a projection having a diameter smaller than that of said shaft portion and projected from the end surface thereof.

10. An apparatus for manufacturing a semiconductor device as set forth in claim 8, wherein said hold pin is comprised of a tapered pin (70a, 70b) such that the extreme end of said front end portion (71a, 71b) is formed tapered to serve as a pressure receiving surface.

11. An apparatus for manufacturing a semiconductor

tor device as set forth in claim 9 or 10, wherein said hold pins (7a, 7b, 70a, 70b) are such that a molding pressure of plastic material injected onto said pressure receiving surfaces or said pressure tapered surfaces (71a, 71b) formed at said front end portions is applied, whereby said hold pins are moved by a predetermined distance (C) from the both surfaces of said opposite end portion (1d) of said lead frame (1) against a resilient force of said spring (8a, 8b), thus to release said holding state.

FIG. I    PRIOR ART

FIG. 2    PRIOR ART

FIG. 3    PRIOR ART

FIG. 4    PRIOR ART

FIG. 5A    PRIOR ART

FIG. 5B    PRIOR ART

FIG. 6

FIG. 7

EP 0 472 199 A1

FIG. 8

FIG. 9

FIG. 10

FIG. 11

FIG. 12

FIG. 13A

FIG. 13B

11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | EP-A-0 257 681   (SGS-THOMSON MICROELECTRONICS)<br>* column 4, line 9 - column 5, line 35; figures 3-7 * * ditto *<br>– – – | 1,2-11 | H 01 L 21/56<br>B 29 C 45/14 |
| Y | GB-A-2 103 534   (OMRON TATEISI ELECTRONICS)<br>* page 1, line 102 - page 2, line 52; figures 3, 4 * * page 3, lines 8 - 58; figure 6 *<br>– – – | 2-11 | |
| A | PATENT ABSTRACTS OF JAPAN vol. 14, no. 19 (M-919)(3962) 16 January 1990,<br>& JP-A-1 262115 (SEIKO EPSON CORP) 19 October 1989,<br>* the whole document *<br>– – – – – | 1-4,6-9, 11 | |
| | | | **TECHNICAL FIELDS SEARCHED (Int. Cl.5)**<br><br>H 01 L<br>B 29 C |

The present search report has been drawn up for all claims

| Place of search | Date of completion of search | Examiner |
|---|---|---|
| Berlin | 08 October 91 | LE MINH I |